# FASCICULE DE BREVET EUROPEEN

(11) **EP 2 697 964 B1**
(45) Date de publication et mention de la délivrance du brevet: **25.05.2016**
(21) Numéro de dépôt: 12714691.8
(22) Date de dépôt: 12.04.2012
(51) Int. Cl.: H04N 5/365, H04N 5/374, G06F 17/50

(54) **PROCEDE AMELIORE DE CONCEPTION D'UNE MATRICE D'ELEMENTS PHOTO-DETECTEURS OU PHOTO-EMETTEURS ORGANIQUES**
VERBESSERTES VERFAHREN FÜR DEN ENTWURF VON ORGANISCHEN PHOTODETEKTOR- ODER PHOTOEMITTERELEMENTEN
IMPROVED METHOD FOR DESIGNING AN ARRAY OF ORGANIC PHOTODETECTOR OR PHOTOEMITTER ELEMENTS

(30) Priorité: 15.04.2011 FR 1153311
(43) Date de publication de la demande: 19.02.2014
(73) Titulaire: Commissariat à l'Énergie Atomique et aux Énergies Alternatives, 75015 Paris (FR); ISORG, 38000 Grenoble (FR)
(72) Inventeur: PREMONT, Christophe, F-38360 Sassenage (FR); GWOZIECKI, Romain, F-38000 Grenoble (FR)
(74) Mandataire: Ahner, Philippe
(86) Numéro de dépôt international: PCT/EP2012/056679
(87) Numéro de publication internationale: WO 2012/140141

(56) Documents cités:
- US-A1- 2006 091 794

## Description

### DOMAINE TECHNIQUE

La présente demande concerne le domaine des dispositifs microélectroniques matriciels d'éléments photo-détecteurs ou photo-émetteurs, et en particulier ceux formés d'éléments, de photo-détection ou de photo-émission, passifs.

Elle prévoit un procédé amélioré de conception d'un dispositif matriciel d'éléments photo-détecteurs ou photo-émetteurs, ainsi qu'un dispositif matriciel mis en oeuvre selon un tel procédé.

La présente invention trouve notamment des applications dans la réalisation de matrices d'éléments photodétecteurs ou photo-émetteurs à base de matériau semi-conducteur organique.

### ÉTAT DE LA TECHNIQUE ANTÉRIEURE

Dans un capteur d'image formé d'une matrice d'éléments photo-détecteurs, l'information détenue par chacun des éléments photo-détecteurs se trouve généralement sous forme d'un courant ou d'une tension.

Lorsqu'une matrice est constituée de pixels ou d'éléments, photo-détecteurs ou photo-émetteurs, qui n'intègrent pas de ressource de traitement localisé au niveau du pixel lui-même, ces pixels sont généralement qualifiés de « passifs ».

Actuellement, les capteurs d'image réalisés sur silicium, tels que les capteurs à transfert de charge ou CCD (CCD pour « charge coupled device »), ou les capteurs en technologie CMOS sont formés de pixels actifs, c'est-à-dire de pixels, qui en plus de la fonction de détection, intègrent localement des moyens de traitement de signal, par exemple des moyens réalisant une fonction de pré-charge ou/et d'amplification, ou de multiplexage.

Des pixels actifs permettent d'obtenir des améliorations en termes de qualité d'image et de vitesse de lecture du capteur.

Pour des raisons de difficulté de mise en oeuvre du procédé de fabrication, les capteurs d'image à base de photo-détecteurs organiques, c'est-à-dire formés à base d'au moins un matériau semi-conducteur organique, sont quant à eux actuellement formés d'éléments ou de pixels, passifs.

Lorsque les photodiodes d'une matrice de photodiodes sont illuminées, ces dernières se trouvent en basse impédance et créent des chemins de courant parasites, ce qui peut avoir pour effet d'empêcher d'effectuer une lecture de l'information détenue sous forme de courant ou de tension par chaque pixel.

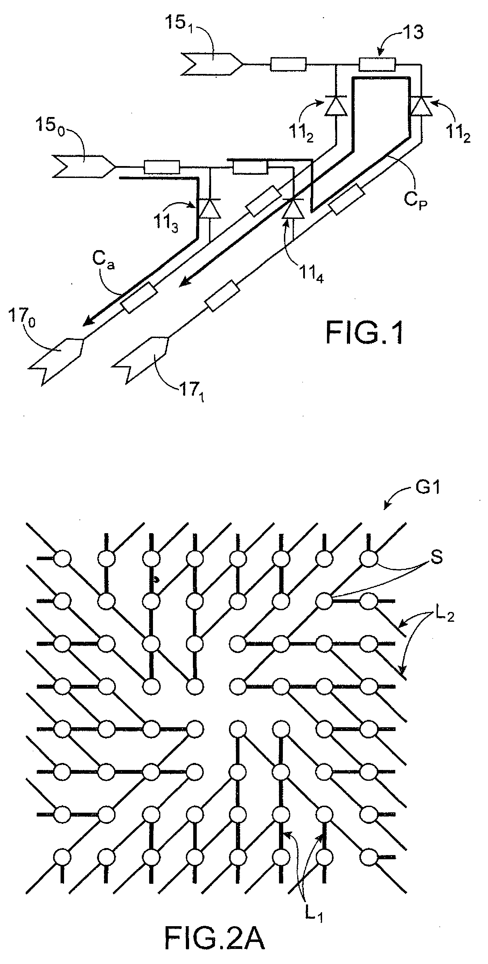

Un exemple d'un tel phénomène est illustré sur le dispositif de la figure 1 donnant un schéma électrique équivalent d'une portion de matrice de photo-détecteurs comportant 2 lignes et 2 colonnes de photodiodes 11₁, 11₂, 11₃, 11₄.

Dans cet exemple, les photodiodes de la matrice sont polarisées en inverse, de sorte qu'une photodiode 11₃ donnée dont on souhaite lire le courant, a par exemple une cathode 15₀ mise à +1 volt, tandis que son anode 17₀ est par exemple polarisée à 0 volt.

Les résistances d'interconnexion 13, les électrodes 15₀, 15₁, 17₀, 17₁, de polarisation, ainsi qu'un chemin Cₐ du courant destiné à être produit par la photodiode 11₃ et un chemin Cₚ du courant parasite traversant les mailles voisines ou adjacentes à celle du pixel que l'on souhaite lire, sont représentés sur cette figure.

Afin de résoudre ce problème de circuits de conduction parasites et permettre une lecture améliorée d'un pixel, une méthode consiste à introduire des diodes supplémentaires entre les pixels de la matrice.

Une telle méthode est présentée par exemple dans les documents US 3 855 582 et « a Word-organised photo detector area », Vilkomerson et al. IEEE journal of solide state circuits, vol. sc-4, n°6, December 1969.

Une telle solution est cependant difficilement applicable aux matrices à base de photo-détecteurs à semi-conducteur organique, notamment pour des raisons de complexité du procédé de fabrication, et en particulier de complexité de mise en oeuvre des diodes supplémentaires entre les pixels.

D'autres solutions au problème susvisé qui nécessiteraient d'intégrer des transistors et des photo-détecteurs sur un même substrat sont également difficilement applicables aux matrices à base de photo-détecteurs à semi-conducteur organique, également pour des raisons de difficulté de mise en oeuvre.

### EXPOSÉ DE L'INVENTION

L'invention concerne tout d'abord un procédé de réalisation d'un dispositif matriciel comprenant une matrice de pixels ou éléments, photo-détecteurs ou photoémetteurs, comme défini dans la revendication 1. Le procédé comprend des étapes de conception consistant à :
a) identifier, à partir d'au moins une topologie donnée (communément appelée « layout ») dudit dispositif matriciel, un ou plusieurs circuits fermés de conduction de courant, en particulier des circuits de conduction parasite,
b) sélectionner un ou plusieurs éléments photo-détecteur(s) ou photoémetteur(s) donné(s) du dispositif matriciel appartenant à au moins un desdits circuits fermés de conduction identifiés, au moins un desdits élément(s) sélectionné à l'étape b) de la matrice étant ensuite rendu inactif ou identifié comme destiné à être rendu inactif.

Le procédé de conception comprend au moins une ou plusieurs étapes de conception assistées par ordinateur ou réalisées à l'aide de moyens de traitement informatique.

Les étapes a) et b) de conception peuvent être en particulier assistées par ordinateur ou réalisées à l'aide de moyens de traitement informatique.

Le procédé comprend en outre au moins une étape de conception consistant à produire une nouvelle topologie dudit dispositif matriciel dans laquelle ledit au moins un élément(s) sélectionné à l'étape b) est rendu inactif ou est identifié comme destiné à être rendu inactif.

Le procédé de réalisation comprend à l'étape a) :
- la mise en oeuvre, à partir de ladite topologie donnée, d'au moins un graphe formé de sommets correspondant auxdits éléments de la matrice et de liens correspondant à des connexions desdits éléments dans la matrice,
- l'identification d'un ou plusieurs cycles donnés dans ledit graphe.

L'étape b) est réalisée par sélection d'au moins un sommet donné appartenant à au moins un desdits cycles dudit graphe.

Ainsi, à l'aide d'au moins un graphe équivalent, on identifie des circuits conducteurs parasites potentiels dans la topologie donnée, puis on sélectionne un ou plusieurs éléments photo-détecteur(s) ou photoémetteur(s) donné(s) appartenant à ce ou ces circuits, dont au moins un d'entre eux est destiné à être rendu inactif.

Ledit sommet donné sélectionné peut être commun à deux cycles dudit graphe.

On cherche à minimiser le nombre d'éléments à rendre inactifs tout en choisissant des éléments de la matrice appartenant à plusieurs circuits conducteurs parasites.

Selon une autre possibilité, ledit sommet donné sélectionné peut appartenir à un cycle de longueur supérieure à une longueur prédéterminée ou au plus grand cycle dudit graphe.

On cherche à minimiser le nombre d'éléments à rendre inactifs tout en choisissant des éléments de la matrice appartenant à un circuit conducteur parasite de taille importante.

Le procédé de réalisation selon l'invention peut comprendre en outre une étape consistant à fabriquer ledit dispositif matriciel, dans lequel au moins un élément(s) sélectionné à l'étape b) est inactif.

Le ou lesdits élément(s) sélectionnés peut ou peuvent être rendu(s) inactif(s) en prévoyant au moins une de leurs électrode (s) qui n'est pas connectée(s) au reste de la matrice.

Le ou lesdits élément(s) sélectionnés peuvent être également rendu(s) inactif(s) en prévoyant une zone de masquage en regard de leur zone semi-conductrice de détection ou d'émission.

Selon une autre possibilité de mise en oeuvre, on peut prévoir les éléments rendus inactifs ou destinés à être rendus inactifs, sans zone semi-conductrice de détection ou d'émission, ou avec une zone isolante remplaçant la zone semi-conductrice de détection.

Selon une autre possibilité de mise en oeuvre, les éléments peuvent être rendus inactifs par traitement physique ou chimique de leur zone semi-conductrice de photo-détection ou de photoémission.

Le procédé selon l'invention s'applique en particulier à la réalisation d'un dispositif dans lequel les éléments de la matrice sont des photodiodes à semi-conducteur organique.

L'invention concerne également un programme d'ordinateur comprenant des instructions de code de programme enregistrable dans cet ordinateur pour exécuter des étapes d'un procédé de conception tel que défini plus haut.

L'invention concerne également un produit programme d'ordinateur comprenant des instructions de code de programme enregistré sur un support utilisable dans un ordinateur, comprenant des moyens de programmation lisibles pour la mise en oeuvre d'un procédé de conception tel que défini plus haut.

L'invention concerne également un support de données numérique utilisable par un ordinateur, comprenant des instructions de code d'un tel programme d'ordinateur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 représente un schéma électrique équivalent d'une portion de matrice de photodiodes dans laquelle on identifie un circuit conducteur parasite,
- les figures 2A-2C illustrent des étapes d'un exemple de procédé de conception suivant l'invention d'une matrice d'éléments photo-détecteurs ou photoémetteurs, à l'aide de graphes équivalents,
- la figure 3 illustre une méthode de sélection d'éléments photo-détecteurs ou photoémetteurs à désactiver pour former une matrice d'éléments photoconducteurs ou photoémetteurs suivant l'invention à l'aide d'un graphe équivalent,
- la figure 4 illustre une variante de méthode de sélection d'éléments photo-détecteurs ou photoémetteurs à désactiver pour former une matrice d'éléments photoconducteurs ou photoémetteurs suivant l'invention à l'aide d'un graphe équivalent,
- la figure 5 illustre une autre variante d'une telle méthode de sélection d'éléments photo-détecteurs ou photoémetteurs à désactiver,
- la figure 6 illustre une autre variante de méthode de sélection d'éléments photo-détecteurs ou photoémetteurs à désactiver,
- les figures 7A-7B illustrent une modification d'un graphe équivalent mis en oeuvre lors d'un exemple de procédé de conception suivant l'invention,
- la figure 8 illustre un empilement de couches dans lequel une matrice de photodiodes organiques mise en oeuvre suivant l'invention peut être réalisé,
- les figures 9A-9E illustrent différentes méthodes pour rendre une photodiode organique inactive lors de la réalisation d'une matrice de photodiodes suivant l'invention,
- la figure 10 illustre un exemple de graphes mis en oeuvre lors d'un procédé de conception d'un dispositif matriciel suivant l'invention dans lequel la matrice est formée de plusieurs zones indépendantes,
- les figures 11A-11C illustrent un système informatique pour la mise en oeuvre d'un procédé de conception suivant l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé suivant l'invention, de réalisation d'un dispositif matriciel formé d'une pluralité d'éléments photo-détecteurs, va à présent être décrit.

Dans l'exemple donné, les éléments de la matrice sont des photodiodes, en particulier des photodiodes à semi-conducteur organique.

La réalisation de la matrice comporte une phase de conception durant laquelle une première topologie communément appelée « lay-out » du dispositif matriciel est mise en oeuvre.

Cette première topologie comprend notamment un plan de routage des composants de la matrice.

A partir de cette première topologie, on produit au moins un premier graphe. Ce graphe est composé de noeuds ou sommets, correspondant aux éléments photo détecteurs, ainsi que d'arêtes ou liens représentatifs d'un plan de routage prévisionnel de la matrice.

Selon une possibilité de mise en oeuvre du graphe, les arêtes ou liens du graphe peuvent être pondérés, par exemple en fonction de la valeur de résistance des matériaux utilisés pour former les photodiodes et leurs connexions respectives.

Sur l'exemple de graphe G1 de la figure 2A, les sommets S correspondent à des photodiodes, tandis que les liens L1 et L2 correspondent respectivement, à des connexions d'anodes de photodiodes, et des connexions de cathodes de photodiodes.

A l'aide de cette première topologie, on identifie des circuits conducteurs fermés de la matrice susceptibles de conduire un courant, en particulier un courant parasite notamment lorsqu'on réalise un accès en lecture de la matrice.

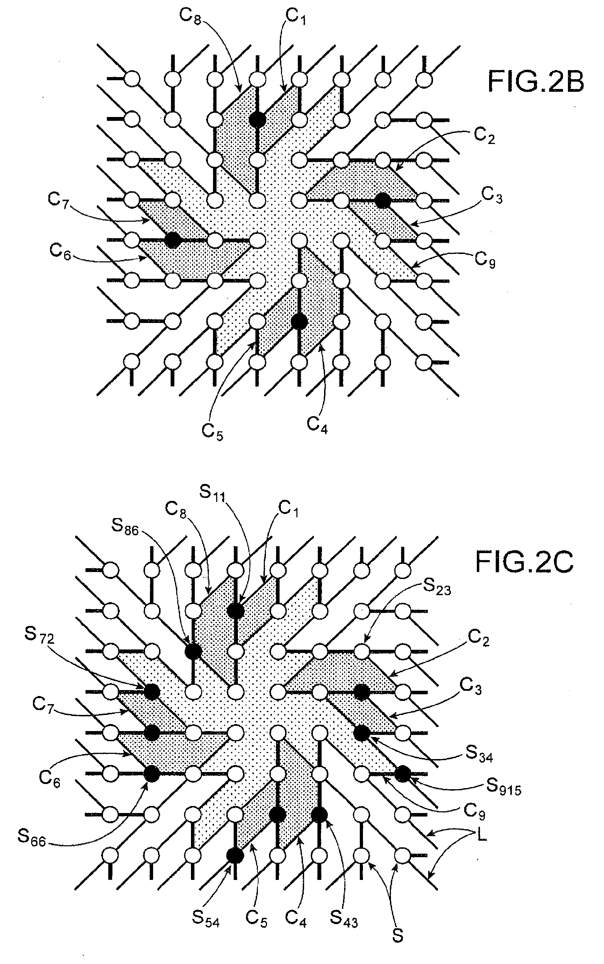

Cette identification peut être réalisée à l'aide d'une identification de cycles C₁, C₂, C₃, C₄, C₅, C₆, ..., C₉, du graphe G1, c'est-à-dire d'une suite de liens consécutifs dont les deux sommets extrémités sont identiques (figure 2B).

Dans un des dits circuits conducteurs identifiés, ou dans plusieurs desdits circuits conducteurs identifiés, voire dans chaque circuit conducteur identifié, on effectue ensuite une sélection d'au moins un élément photo-détecteur.

Ramené au premier graphe G1, cette étape consiste à sélectionner dans un des cycles identifiés C₁,..., C₉, ou dans plusieurs desdits cycles identifiés C₁,..., C₉, voire dans chacun des cycles identifiés C₁, ..., C₉, au moins un sommet donné.

Sur l'exemple de la figure 2C, dans chacun des cycles identifiés C₁, C₂, C₃, C₄, C₅, C₆, C₇, C₈, C₉ du graphe on a sélectionné un sommet S₁₁, S₂₃, S₃₄, S₄₃, S₅₄, S₆₆, S₇₂, S₈₆.

On peut également sélectionner un ou plusieurs sommets dans le ou les cycles du graphe G1 de longueur la plus importante. Le terme « longueur » correspond ici au nombre total de sommets de ce cycle.

En effectuant cette sélection de sommet(s), on détermine ainsi un ou plusieurs éléments photo-détecteur(s) donné(s) du dispositif matriciel appartenant au(x) plus grand(s) circuit(s) fermé(s) de conduction, en particulier de conduction parasite.

Ramené à la topologie d'une matrice de photodiodes, les cycles de longueur la plus importante correspondent aux circuits de conduction dans lesquels se trouvent le plus grand nombre de photodiodes.

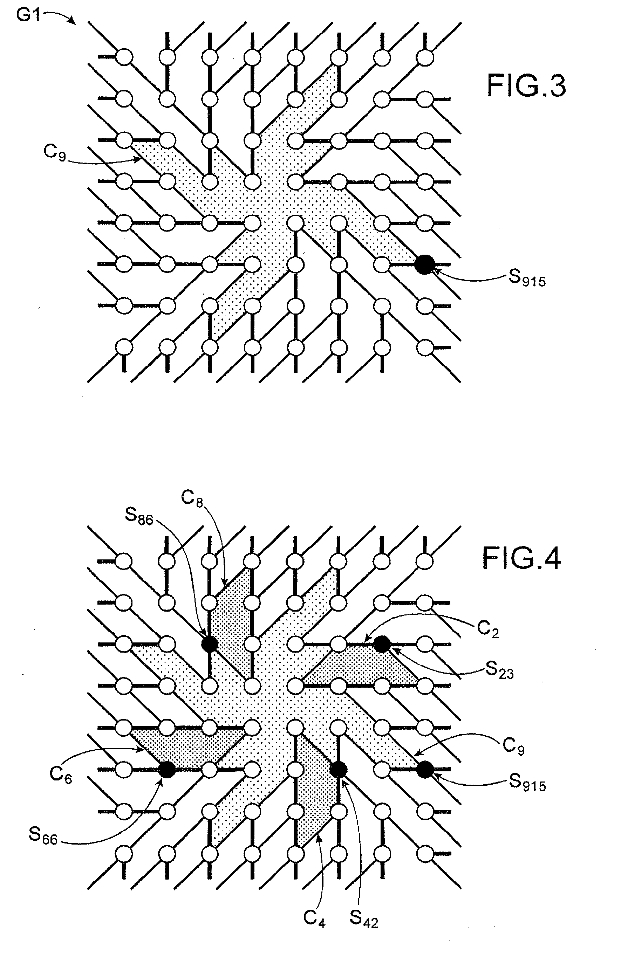

Dans l'exemple de la figure 3, le sommet S₉₁₅ a été sélectionné dans un cycle C₉ qui a été identifié comme le cycle du graphe G1 de longueur maximale.

Selon une possibilité de mise en oeuvre de cette phase de conception, on sélectionne un ou plusieurs sommets dans le ou les cycle(s) du graphe qui ont une longueur supérieure à une longueur prédéterminée.

Par cette sélection de sommet(s), on détermine ainsi un ou plusieurs éléments photo-détecteur(s) ou photoémetteur(s) donné (s) du dispositif matriciel, qui appartiennent à des circuits fermés de conduction passant par un nombre prédéterminé d'éléments photo-détecteurs.

Sur l'exemple de la figure 4, des sommets S₂₃, S₄₂, S₆₆, S₈₆, S₉₁₅ ont été sélectionnés dans des cycles identifiés C₂, C₄, C₆, C₈, C₉, ayant une longueur supérieure ou égale à une longueur prédéterminée de 5.

Cette phase de sélection de sommets permet de déterminer des éléments photo-détecteurs de la matrice qui sont destinés à être inactifs ou rendus inactifs ou être placés en haute impédance dans la matrice de photo-détecteurs que l'on réalise.

A la fin de la phase de sélection, chacun des sommets sélectionnés correspond à un élément photo-détecteur que l'on va rendre inactif.

Par « inactif », on entend, dans le cas d'éléments photo-détecteurs, que la fonction de ces éléments de détection est désactivée ou supprimée ou empêchée et/ou qu'ils ne peuvent participer à l'acquisition d'une image par la matrice.

Selon un mode de réalisation avantageux, on sélectionne des sommets du graphe G1 qui sont communs à plusieurs cycles, en particulier qui sont communs à 2 cycles du graphe.

On cherche ainsi à réduire autant que possible le nombre de circuits conducteurs parasites de la matrice tout en essayant de minimiser le nombre d'éléments photo détecteurs que l'on rend inactif.

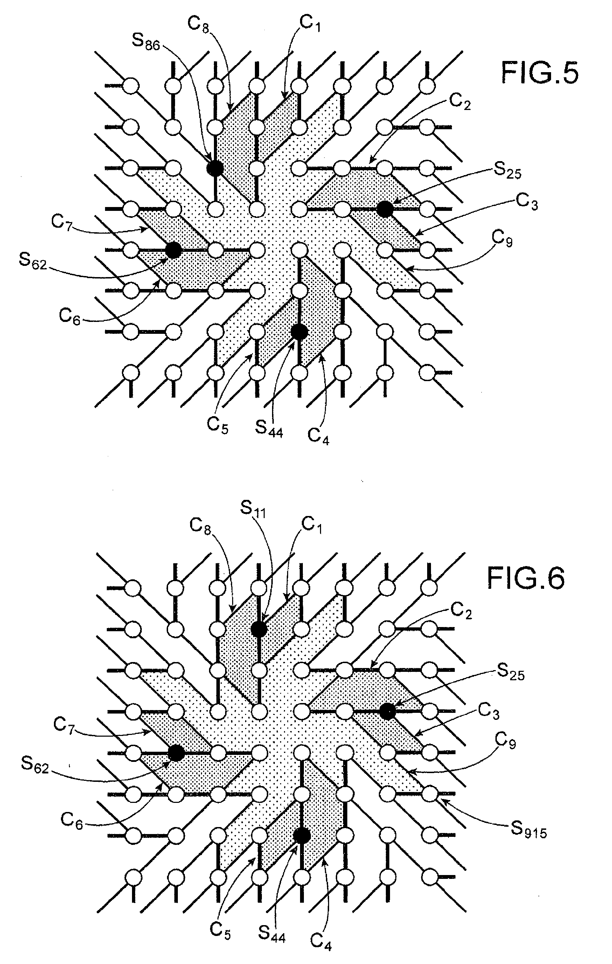

Sur l'exemple de la figure 5, des sommets S₂₅, S₄₄, S₆₂, S₈₆ sélectionnés sont communs respectivement aux paires de cycles identifiés C₂ et C₃, C₄ et C₅, C₆ et C₇, C₈ et C₉

La sélection de sommets et donc du pixel que l'on va rendre inactif peut dépendre de la façon dont on va rendre ce pixel inactif.

Ce mode de sélection de sommets communs à deux cycles, peut être combiné à l'un ou l'autre de ceux décrits plus haut, consistant à sélectionner des sommets dans des cycles de plus grande longueur ou dans des cycles ayant une longueur supérieure à une longueur prédéterminée.

Sur l'exemple de la figure 6, des sommets S₁₁, S₂₅, S₄₄, S₆₂, ont tout d'abord été sélectionnés parce qu'ils sont communs respectivement aux paires de cycles identifiés C₁ et C₈, C₂ et C₃, C₄ et C₅, C₆ et C₇, tandis que le sommet S₉₁₅ a quant à lui été sélectionné dans le cycle C₉ identifié de longueur maximale. Ces 5 sommets sélectionnés correspondent à 5 éléments photo-détecteurs qui sont destinés à être rendus inactifs dans la matrice de photo-détecteurs.

La sélection d'un sommet donné du graphe peut être réalisée également de sorte que lorsqu'on sélectionne ce sommet commun à deux cycles et que l'on supprime les liens qui lui sont rattachés, on supprime au moins un des cycles auquel ce sommet appartient sans créer de nouveau cycle.

Selon une possibilité de mise en oeuvre, la sélection peut être réalisée uniquement sur certaines zones de la matrice, d'autres zones données étant exclues de cette étape de sélection. On empêche ainsi de rendre inactifs des éléments photodétecteurs appartenant à ces zones données.

La sélection peut être réalisée de sorte que les sommets sélectionnés ont une répartition homogène ou une répartition présentant une symétrie, ce qui peut permettre de par la suite de faciliter le traitement d'une image issue de la matrice.

Cette étape de sélection de sommets, peut également être mise en oeuvre de sorte à minimiser ou à rendre nul le nombre de sommets sélectionnés adjacents, ou voisins, ou proches, c'est-à-dire éloignés d'une distance inférieure à une distance prédéterminée

On peut ainsi conditionner la sélection d'un sommet en fonction d'une éventuelle sélection de ses voisins ou des sommets qui lui sont adjacents. On minimise ainsi le nombre d'éléments photodétecteurs adjacents ou voisins ou proches que l'on rend inactif dans la matrice.

Selon une possibilité de mise en oeuvre, un nouveau graphe G2 peut être formé à partir du premier graphe G1 dans lequel des sommets ont été sélectionnés.

Ce nouveau graphe G2, peut être formé à partir du premier graphe G1, en supprimant au moins un lien rattaché à chaque sommet sélectionné du premier graphe G1.

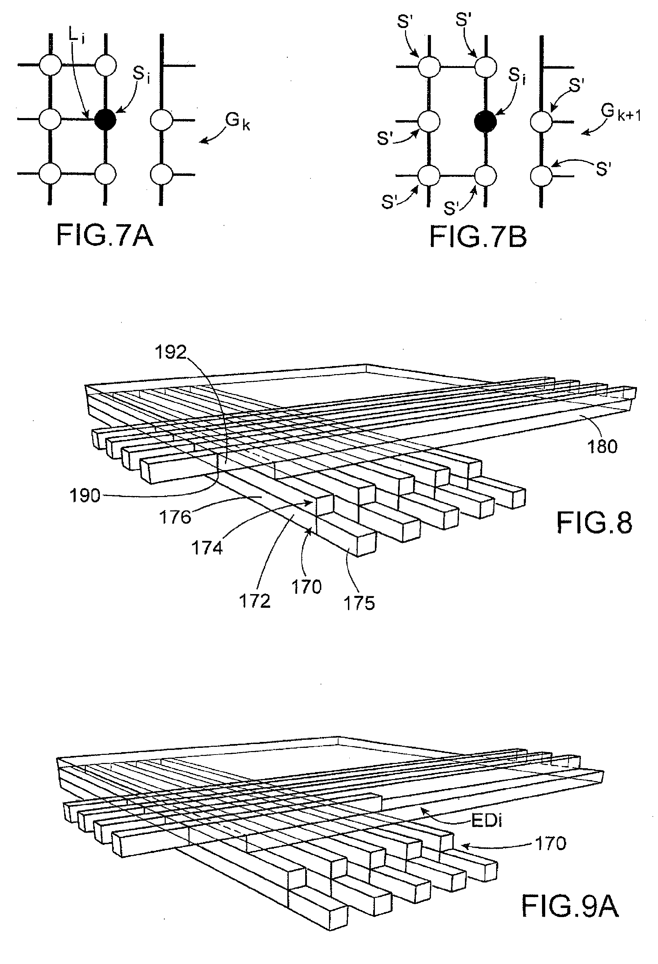

Sur les figures 7A-7B, un exemple d'une telle suppression est illustré.

Des traitements d'identification et de sélection tels que décrits précédemment ont permis de sélectionner un sommet donné Si correspondant à un élément photodétecteur que l'on souhaite rendre inactif dans un graphe Gₖ correspondant à une matrice de photodétecteurs (figure 7A).

On supprime alors un lien Lᵢ rattaché au sommet Si sélectionné de manière à former un nouveau graphe Gₖ₊₁ (figure 7B). Dans cet exemple, le lien Lᵢ peut être représentatif d'une connexion d'anode ou de cathode de l'élément photodétecteur correspondant au sommet sélectionné Sᵢ. Ce lien Lᵢ supprimé est choisi de préférence de manière à ne pas rendre inactif les éléments photodétecteurs correspondants aux sommets S' voisins du sommet donné Sᵢ sur le graphe.

Les étapes d'identification de cycle et de sélection de sommet peuvent être réitérées dans ce nouveau graphe Gₖ₊₁.

Un procédé itératif dans lequel des étapes d'identification et de sélection telles que décrites plus haut sont mises en oeuvre par exemple tant que des cycles apparaissent dans le graphe courant.

Ensuite, en fonction du graphe finalement obtenu et des sommets de ce graphe qui ont été sélectionnés, on modifie ladite première topologie et l'on produit une nouvelle topologie.

Dans cette nouvelle topologie, plusieurs éléments photo-détecteurs sont rendus inactifs ou identifiés comme destinés à être rendus inactifs.

Cette nouvelle topologie T₂ ou « layout » peut être réalisé(e) en modifiant le routage de la matrice suivant ladite première topologie T₁.

Ainsi il peut être prévu de rendre un élément photo-détecteur inactif au sein même de la nouvelle topologie T₂ et ensuite de fabriquer la matrice en suivant cette nouvelle topologie T₂.

Selon une autre possibilité, il peut être prévu de désigner ou d'identifier les éléments photo-détecteurs à rendre inactifs dans une topologie et ensuite de fabriquer la matrice en rendant lesdits éléments photo-détecteurs désignés inactifs.

La matrice réalisée peut être par exemple formée d'éléments photo-détecteurs sous forme de photodiodes à base de matériau semi-conducteur organique et réalisée à partir d'un empilement du type de celui donné sur la figure 8.

Les anodes 170 des photodiodes sont réalisées dans une couche à base d'un matériau 172 conducteur et transparent tel que l'ITO (ITO pour « Indium Tin Oxide ») et d'une couche 174 à base d'un matériau 176 tel que du Poly(3,4-ethylenedioxythiophene) poly(styrenesulfonate) communément appelé PEDOT:PSS, permettant de favoriser le contact ohmique avec une couche de matériau semi-conducteur organique 180.

Les motifs de la couche de matériau 172 conducteur et transparent, par exemple sous forme de barreaux parallèles, sont superposés à ceux formés dans la couche du matériau 176 et peuvent être identiques à ces derniers. Des zones de contacts 175 métalliques, par exemple à base de TiAu, sont formées aux extrémités de chaque anode 170.

Le matériau semi-conducteur organique 180, par exemple tel que un mélange hétérojonction de polymère donneur, par exemple tel que du P3HT (pour « poly(3-hexylthiophène) »), et de polymère accepteur, par exemple tel que du PCBM (pour phenylC₆₆ butyric acid methyl ester) donneur et accepteur peut être formé de manière à recouvrir l'ensemble des anodes 170.

Des cathodes 190, par exemple sous forme de barreaux parallèles, sont disposées sur la couche de matériau semi-conducteur organique 180. Ces cathodes 190 peuvent être par exemple à base d'aluminium.

Un élément photo-détecteur sous forme d'une photodiode peut être par exemple rendu inactif en supprimant toute connexion de son anode, et/ou de sa cathode, avec le reste de la matrice, en détruisant la diode ou en masquant la diode.

Selon une première réalisation, sur l'exemple de la figure 9A, un élément photo-détecteur inactif Edi, formé dans l'empilement précédemment décrit, comporte une anode 170 et est dépourvu de cathode 190.

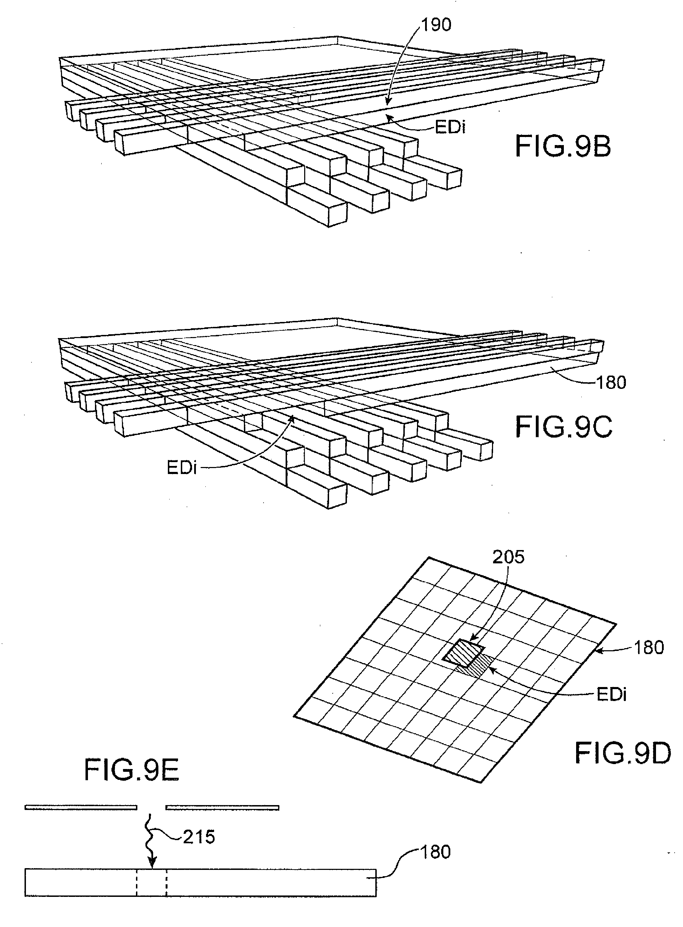

Selon une deuxième réalisation, sur l'exemple de la figure 9B, un élément photo-détecteur inactif Edi formé dans l'empilement précédemment décrit comporte une cathode 190 et est dépourvu d'anode.

Une variante de ces deux réalisations consiste à former des contacts électriques d'anode et/ou de cathode, par exemple par attaque chimique de manière à lui conférérer une haute résistance, par exemple de valeur suffisamment élevée pour que des courant parasites soient de l'ordre du courant d'obscurité, par exemple inférieurs à 1 nA.

Selon une troisième réalisation, une autre possibilité (figure 9C) consiste à prévoir un élément photo-détecteur inactif Edi sans zone semi-conductrice de détection et éventuellement rémplacée par une zone isolante ou avec une zone semi-conductrice de détection détériorée ou détruite.

La détérioration ou destruction peut être réalisée par traitement physique, par exemple à l'aide d'un faisceau laser ou un rayonnement UV (figure 9E) ou bien par traitement chimique, par exemple à l'aide d'une attaque chimique localisée durant laquelle le reste du dispositif est protégé par un masque.

Selon une quatrième réalisation, une autre méthode pour rendre un élément photo-détecteur EDᵢ inactif, consiste à prévoir un masque 205 en regard de la zone semi-conductrice 180 de détection de ces derniers, le masque 202 étant destiné à bloquer le rayonnement que cette zone semi-conductrice 180 est susceptible de transformer en électrons (figure 9D).

Ce masque peut-être réalisé par exemple sous forme d'un feuillet métallique ou d'un dépôt plastique. Par exemple, dans le cas d'un dispositif formé d'un empilement tel que celui décrit en liaison avec la figure 2, ce masque peut être réalisé par des zones métalliques placées au dessus de la couche de matériau semi-conducteur 180, aux endroits où les diodes photo-détectrices à inactiver sont disposées.

Le procédé qui a été décrit précédemment concerne la mise en oeuvre de photo-détecteurs, donc d'éléments récepteurs de lumière qui transforment des photons incidents en électrons.

Ce procédé peut s'appliquer également à la mise en oeuvre d'un dispositif matriciel formé d'éléments émetteurs de lumière ou photo-émetteurs.

On peut en particulier mettre en oeuvre une matrice de diodes électroluminescentes à base de matériau semi-conducteur organique à l'aide du procédé décrit plus haut.

Dans le cas d'éléments photo-émetteurs, par « inactif », on entend, que leur fonction d'émission est désactivée ou empêchée et/ou qu'ils ne peuvent participer à la formation d'une image par la matrice.

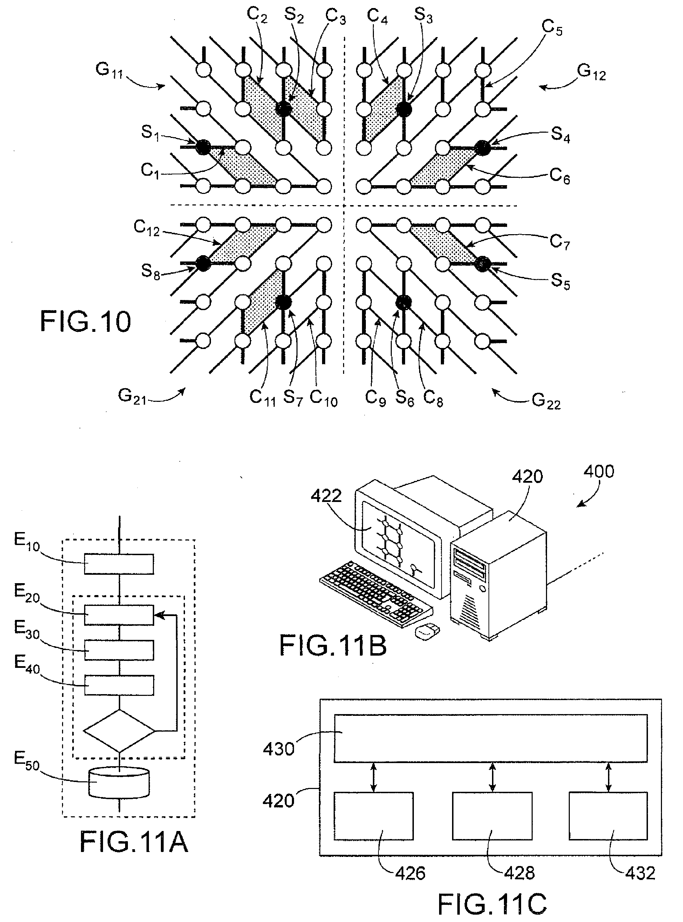

Sur la figure 10, une variante de réalisation est donnée. Un graphe composé de 4 sous-graphes G11, G12, G21, G22 a été formé à partir d'une topologie de matrice de photodiodes comprenant 4 zones juxtaposées mais électriquement indépendantes.

Dans un premier sous-graphe G11 des sommets S1 et S2 appartenant respectivement au cycle C1, et à la paire de cycles C2-C3, ont été identifiés comme correspondant à des éléments de la matrice à rendre inactifs.

Dans un deuxième sous-graphe G12, des sommets S4 et S3 appartenant respectivement au cycle C6, et à la paire de cycles C4-C5, ont été identifiés comme correspondant à des éléments de la matrice à rendre inactifs.

Dans un troisième sous-graphe G13, ce sont des sommets S6 et S5 qui sont destinés à être rendus inactifs, tandis que dans un quatrième sous-graphe G14, ce sont des sommets S7 et S8 qui sont sélectionnés et désignés comme destinés à être rendus inactifs.

La figure 11A est un organigramme d'un procédé de conception de matrice d'éléments photo-détecteurs ou photo-émetteurs suivant l'invention dont certaines opérations décrites précédemment peuvent faire partie.

Selon une première étape, on produit au moins un graphe à partir d'une topologie d'un dispositif matriciel d'éléments photo-détecteurs (étape E10).

Ce premier graphe peut être mis en oeuvre à l'aide d'un dispositif de traitement informatique comportant des moyens de modélisation.

Ensuite, dans ce premier graphe G1, une identification de cycles est effectuée (étape E20).

Puis, une sélection de sommet (s) appartenant aux cycles identifiés (étape E30) est réalisée selon un critère prédéterminé, par exemple en sélectionnant des sommets communs à deux cycles.

Ensuite, un nouveau graphe peut être mis en oeuvre (étape E40) à partir du premier graphe G1 que l'on a modifié en fonction des sommets sélectionnés, par exemple en supprimant un ou plusieurs liens rattachés à ces sommets sélectionnés.

Une ou plusieurs itérations des étapes précédentes peuvent être éventuellement effectuées.

Ces étapes E20, E30 et E40 peuvent être réalisées par un dispositif de traitement informatique 400 ou des moyens de traitement informatisés 400. Un tel dispositif peut être doté de moyens de traitement de graphes mis en oeuvre à l'aide d'algorithmes par exemple réalisés sur un logiciel du type du logiciel Grin 4.8 et/ou du logiciel Matlab 9.2.

On produit ensuite une nouvelle topologie (étape E50) du dispositif matriciel dans laquelle des éléments photo-détecteurs ont été rendus inactifs ou sont identifiés comme destinés à être rendus inactifs.

La figure 11B représente un dispositif de traitement informatique 400 muni d'un ordinateur 420 configuré de manière adaptée pour le traitement de topologies ou layout de circuits électroniques.

L'ordinateur 420 comporte une section de calcul avec tous les composants électroniques, logiciels ou autres, nécessaires à la réalisation de topologies de circuits, à la modélisation d'une topologie de circuit sous forme de graphe, au traitement de graphes, ou à des calculs effectués sur des graphes.

Ainsi, par exemple, le système comporte un processeur programmable 426, et au moins une mémoire 428. le système peut également comprter un périphérique d'entrée, par exemple un disque dur 432, couplés à un bus système 430. Le processeur peut être, par exemple, un microprocesseur, ou un processeur d'unité centrale. La mémoire 428 peut être, par exemple, un disque dur, une mémoire morte ROM, un disque optique compact, une mémoire vive dynamique DRAM ou tout autre type de mémoire RAM, un élément de stockage magnétique ou optique, des registres ou d'autres mémoires volatiles et/ou non volatiles. Des algorithmes de traitement de graphes peuvent être stockées dans la mémoire, et permettent d'effectuer des traitements tels que décrits plus haut sur un graphe obtenu par modélisation d'une topologie de circuit.

Un programme, permettant la mise en oeuvre d'un procédé de conception selon l'invention est résidant ou enregistré sur un support, par exemple un CD ROM ou un DVD ROM, ou un disque dur amovible, ou tout support mémoire susceptible d'être lu par un système informatique.

L'ordinateur 420 peut être également relié à d'autres dispositifs périphériques, tel que par exemple, un dispositif d'affichage tel qu'un écran 422.

Il est ainsi possible d'afficher sur l'écran 422 une image représentative d'un résultat de traitement de graphe, tel que décrit précédemment ou une nouvelle topologie de dispositif matriciel dans laquelle des éléments photo-détecteurs ou photo-émetteurs ont été rendus inactifs ou sont désignés comme destinés à être rendus inactifs.

Le dispositif informatique peut être relié à un réseau, par exemple de type Internet, permettant d'envoyer des données de graphes et/ou de topologies d'un dispositif matriciel à un autre dispositif distant.

## Revendications

1. Procédé de réalisation d'un dispositif matriciel comprenant une matrice d'éléments, photo-détecteurs ou photo-émetteurs, le procédé comprenant des étapes de conception par le biais de moyens de traitement informatique réalisant des étapes consistant à :
a) identifier, à partir d'au moins une topologie donnée dudit dispositif matriciel, un ou plusieurs circuits fermés de conduction de courant, cette identification comprenant
- la mise en oeuvre, à partir de ladite topologie donnée, d'au moins un graphe formé de sommets correspondant auxdits éléments de la matrice et de liens correspondant à des connexions desdits sommets dans la matrice,
- l'identification d'un ou plusieurs cycles donnés dans ledit graphe,
b) sélectionner un ou plusieurs éléments photo-détecteur(s) ou photo-émetteur(s) donné(s) du dispositif matriciel appartenant à au moins un desdits circuits fermés de conduction identifiés, cette sélection étant réalisée par sélection d'au moins un sommet donné appartenant à au moins un desdits cycles dudit graphe,
au moins un desdits élément(s) sélectionné à l'étape b) de la matrice étant rendu inactif ou étant identifié comme destiné à être rendu inactif,
puis
- produire une nouvelle topologie dudit dispositif matriciel dans laquelle ledit au moins un élément(s) sélectionné à l'étape b) par les moyens de traitement informatique est rendu inactif ou identifié comme destiné à être rendu inactif.

2. Procédé de réalisation d'un dispositif matriciel selon la revendication 1, dans lequel ledit sommet donné sélectionné est commun à deux cycles dudit graphe.

3. Procédé de réalisation d'un dispositif matriciel selon la revendication 1 ou 2, dans lequel ledit sommet donné sélectionné appartient à un cycle de longueur supérieure à une longueur prédéterminée ou appartient au plus grand cycle dudit graphe.

4. Procédé de réalisation d'un dispositif matriciel selon l'une des revendications 1 à 3, comprenant en outre, l'étape consistant à fabriquer ledit dispositif matriciel, ledit au moins un élément(s) sélectionné à l'étape b) étant inactif.

5. Procédé de réalisation d'un dispositif matriciel selon l'une des revendications 1 à 4, dans lequel le ou lesdits élément(s) sélectionnés sont rendu(s) inactif(s) en prévoyant au moins une de leurs électrode(s) déconnectée(s) du reste de la matrice.

6. Procédé de réalisation d'un dispositif matriciel selon l'une des revendications 1 à 5, dans lequel les éléments de la matrice comportent une zone semi-conductrice, de détection de photons ou d'émission de photons, le ou lesdits élément(s) sélectionnés étant rendu(s) inactif(s) en prévoyant une zone de masquage en regard de ladite zone semi-conductrice.

7. Procédé de réalisation d'un dispositif matriciel selon l'une des revendications 1 à 6, dans lequel lesdits éléments rendus inactifs ou destinés à être rendus inactifs, sont prévus sans zone semi-conductrice de photo-détection ou de photo-émission ou avec une zone isolante remplaçant la zone de photo-détection ou de photo-émission.

8. Procédé de réalisation d'un dispositif matriciel selon l'une des revendications 1 à 7, dans lequel lesdits éléments sélectionnés sont formés avec une zone semi-conductrice de photo-détection ou de photo-émission, rendue inactive.

9. Procédé de réalisation d'un dispositif matriciel selon l'une des revendications 1 à 8, dans lequel lesdits éléments de la matrice sont des diodes à semi-conducteur organique.

10. Programme d'ordinateur comprenant des instructions de code de programme enregistrable dans cet ordinateur pour exécuter des étapes du procédé suivant l'une quelconque des revendications 1 à 3.

11. Produit programme d'ordinateur comprenant des instructions de code de programme enregistré sur un support utilisable dans un ordinateur, comprenant des moyens de programmation lisibles pour la mise en oeuvre d'un procédé suivant l'une quelconque des revendications 1 à 3.

12. Support de données numérique utilisable par un ordinateur, comprenant des instructions de code d'un programme d'ordinateur selon l'une des revendications 10 ou 11.

## Patentansprüche

1. Verfahren zum Herstellen einer Matrix-Vorrichtung, umfassend eine Matrix aus Fotodetektor- oder Fotoemitter-Elementen, wobei das Verfahren Entwicklungsschritte mittels Datenverarbeitungsmitteln umfasst, welche Schritte ausführen, bestehend aus:
a) ausgehend von wenigstens einer gegebenen Topologie der Matrix-Vorrichtung, Identifizieren von einem oder mehreren geschlossenen stromleitenden Kreisen, wobei das Identifizieren umfasst:
- ausgehend von der gegebenen Topologie, Bilden von wenigstens einem geschlossenen Graphen, welcher aus Knoten, welche den Elementen der Matrix entsprechen, und Linien gebildet ist, welche den Verbindungen der Knoten in der Matrix entsprechen,
- das Identifizieren von einem oder mehreren gegebenen Zyklen in dem Graphen,
b) Auswählen von einem oder mehreren gegebenen Fotodetektor- oder Fotoemitter-Elementen der Matrix-Vorrichtung, welche(s) zu wenigstens einem der identifizierten geschlossenen stromleitenden Kreisen zugehörig ist, wobei diese Auswahl durch Auswählen von wenigstens einem gegebenen Knoten durchgeführt wird, welcher wenigstens einem der Zyklen des Graphen zugehörig ist,
wobei wenigstens eines der in Schritt b) ausgewählten Elemente der Matrix inaktiv gemacht wird oder als inaktiv zu machend bestimmt identifiziert wird,
hiernach
- Darstellen einer neuen Topologie der Matrix-Vorrichtung, in welcher wenigstens ein in Schritt b) durch die Datenverarbeitungsmittel ausgewähltes Element inaktiv gemacht wird oder als inaktiv zu machend bestimmt identifiziert wird.

2. Verfahren zum Herstellen einer Matrix-Vorrichtung nach Anspruch 1, wobei der gegebene ausgewählte Knoten zwei Zyklen des Graphen gemein ist.

3. Verfahren zum Herstellen einer Matrix-Vorrichtung nach Anspruch 1 oder 2, wobei der gegebene ausgewählte Knoten einem Zyklus zugehörig ist, welcher von einer Länge ist, welche größer als eine vorbestimmte Länge ist, oder dem größten Zyklus des Graphen zugehörig ist.

4. Verfahren zum Herstellen einer Matrix-Vorrichtung nach einem der Ansprüche 1 bis 3, ferner umfassend den Schritt, bestehend aus einem Fabrizieren der Matrix-Vorrichtung, wobei das wenigstens eine in Schritt b) ausgewählte Element inaktiv ist.

5. Verfahren zum Herstellen einer Matrix-Vorrichtung nach einem der Ansprüche 1 bis 4, wobei das oder die ausgewählte(n) Element(e) inaktiv gemacht wird/werden, indem wenigstens eine ihrer Elektroden vom Rest der Matrix getrennt vorgesehen werden.

6. Verfahren zum Herstellen einer Matrix-Vorrichtung nach einem der Ansprüche 1 bis 5, wobei die Elemente der Matrix eine Halbleiter-Zone zur Detektion von Photonen oder zur Emission von Photonen umfassen, wobei das oder die ausgewählte(n) Element(e) inaktiv gemacht wird/werden, indem eine Maskierungszone bezüglich der Halbleiter-Zone vorgesehen wird.

7. Verfahren zum Herstellen einer Matrix-Vorrichtung nach einem der Ansprüche 1 bis 6, wobei die inaktiv gemachten Elemente oder die als inaktiv zu machend bestimmten Elemente ohne Halbleiter-Zone zur Fotodetektion oder zur Fotoemission oder mit einer isolierenden Zone vorgesehen sind, welche die Zone zur Fotodetektion oder zur Fotoemission ersetzt.

8. Verfahren zum Herstellen einer Matrix-Vorrichtung nach einem der Ansprüche 1 bis 7, wobei die ausgewählten Elemente mit einer inaktiv gemachten Halbleiter-Zone zur Fotodetektion oder zur Fotoemission gebildet werden.

9. Verfahren zum Herstellen einer Matrix-Vorrichtung nach einem der Ansprüche 1 bis 8, wobei die Elemente der Matrix organische Halbleiterdioden sind.

10. Computerprogramm, umfassend Programmcode-Anweisungen, welche auf dem Computer speicherbar sind, um die Schritte des Verfahrens nach einem der Ansprüche 1 bis 3 durchzuführen.

11. Computerprogramm-Produkt, umfassend Programmcode-Anweisungen, welche auf einem Speichermedium gespeichert sind, welches von einem Computer verwendbar ist, umfassend lesbare Programmmittel zum Durchführen eines Verfahrens nach einem der Ansprüche 1 bis 3.

12. Numerischer Datenträger, welcher von einem Computer verwendbar ist, umfassend Computerprogrammcode-Anweisungen nach einem der Ansprüche 10 oder 11.

## Claims

1. A method for making a matrix device comprising a matrix of photodetecting or photoemitting elements, the method comprising designing steps using data processing means consisting in:
a) identifying, from at least one given topology of said matrix device, one or more electrically conducting closed circuits, this identification comprising,
- implementing, from said given topology, at least one graph formed by vertices corresponding to said elements of the matrix and links corresponding to connections of said vertices in the matrix,
- identifying one or more given cycles in said graph,
b) selecting one or more given photodetecting or photoemitting element(s) of the matrix device belonging to at least one of said conducting closed circuits identified,
this selection being performed by selecting at least one given vertex belonging to at least one of said cycles of said graph,
at least one of said element(s) selected in step b) of the matrix being made inactive or being identified as intended to be made inactive, then
- producing a new topology of said matrix device wherein said at least one element selected in step (b) is made inactive or identified as intended to be made inactive.

2. The method for making a matrix device according to claim 1, wherein said given vertex selected is common to two cycles of said graph.

3. The method for making a matrix device according to claim 1 or 2, wherein said given vertex selected belongs to a cycle having a length higher than a predetermined length or belongs to the greatest cycle of said graph.

4. The method for making a matrix device according to one of claims 1 to 3, further comprising the step consisting in manufacturing said matrix device, said at least one element selected in step b) being inactive.

5. The method for making a matrix device according to one of claims 1 to 4, wherein said one or more element(s) selected is (are) made inactive by providing at least one of their electrode(s) disconnected from the remainder of the matrix.

6. The method for making a matrix device according to one of claims 1 to 5, wherein the elements of the matrix include a semi-conducting, photodetecting or photon-emitting zone, said element(s) selected being made inactive by providing a masking zone facing said semi-conducting zone.

7. The method for making a matrix device according to one of claims 1 to 6, wherein said elements made inactive or intended to be made inactive are provided without a photodetecting or photoemitting semi-conducting zone or with an insulating zone replacing the photodetecting or photoemitting zone.

8. The method for making a matrix device according to one of claims 1 to 7, wherein said elements selected are formed with a photodetecting or photoemitting semi-conducting zone, made inactive.

9. The method for making a matrix device according to one of claims 1 to 8, wherein said elements of the matrix are organic semi-conductor diodes.

10. A computer program comprising program code instructions recordable onto this computer to execute steps of the method according to any of claims 1 to 3.

11. A computer program product comprising program code instructions recorded onto a medium usable in a computer, comprising readable programming means for implementing a method according to any of claims 1 to 3.

12. A Digital data medium usable by a computer, comprising code instructions of a computer program according to one of claims 10 or 11.
